# EUROPÄISCHE PATENTSCHRIFT

(11) **EP 3 181 944 B1**
(45) Veröffentlichungstag und Bekanntmachung des Hinweises auf die Patenterteilung: **26.04.2023**
(21) Anmeldenummer: 15200391.9
(22) Anmeldetag: 16.12.2015
(51) Int. Cl.: F16F 15/027, F16F 15/03

(54) **SCHWINGUNGSISOLATOR MIT EINER VERTIKAL WIRKSAMEN PNEUMATISCHEN FEDER**
VIBRATION ISOLATOR WITH A VERTICALLY ACTIVE PNEUMATIC SPRING
ISOLATEUR DE VIBRATIONS DOTÉ D'UN RESSORT PNEUMATIQUE VERTICAL

(43) Veröffentlichungstag der Anmeldung: 21.06.2017
(73) Patentinhaber: Integrated Dynamics Engineering GmbH, 65479 Raunheim (DE)
(72) Erfinder: Evers, Arndt, 65375 Oestrich-Winkel (DE); Hofmann, Frank, 61191 Rosbach (DE)
(74) Vertreter: Blumbach · Zinngrebe Patentanwälte PartG mbB

(56) Entgegenhaltungen:
- EP-A1- 1 803 963
- EP-A2- 1 803 964
- DE-U1- 8 900 312
- US-A1- 2005 211 515

## Beschreibung

### Gebiet der Erfindung

Die Erfindung betrifft einen Schwingungsisolator mit einer pneumatischen Feder, die nur in vertikaler Richtung wirksam ist. Insbesondere betrifft die Erfindung einen Schwingungsisolator, der in einem stationären Schwingungsisolationssystem zur Lagerung von Geräten der Halbleiterindustrie verwendet wird, wie beispielsweise Lithographiegeräte, optische Inspektionsgeräte und Wafer-Handling-Einrichtungen.

### Hintergrund der Erfindung

Aktive und passive Schwingungsisolationssysteme auf Basis von pneumatischen Federn sind bekannt. Durch die passiven Übertragungseigenschaften einer Luftfeder wird eine Schwingungsisolation vom Untergrund bereits oberhalb der Eigenfrequenz des Masse-Feder-Systems erreicht. Lediglich um die Eigenfrequenz herum ergibt sich eine Erhöhung der Schwingungsamplitude, welche in Abhängigkeit von der Dämpfung der Schwingung recht groß sein kann.

Derartige passive Systeme mit pneumatischen Isolatoren werden daher durch eine aktive Regelung verbessert. Hierzu werden Sensoren, insbesondere auf der zu isolierenden Last platziert, welche Beschleunigung, Geschwindigkeit oder den Abstand zum Boden messen und so in der Regel berührenslos angreifenende Aktoren ansteuern, die Kompensationskräfte auf das System ausüben.

Pneumatische Federn werden in der Regel abhängig von der Masse der zu lagernden Last abgestimmt. In manchen Fällen, insbesondere wenn sich die zu lagernde Last ändert, wird zusätzlich eine Niveauregulierung verwendet, mittels der über ein Niveauregelventil die Luftzufuhr und -abfuhr gesteuert wird. Die Luftfedern sind so in das Regelsystem eines aktiven Schwingungsisolationssystems eingebunden.

Die berührungslosen Aktoren, welche ansonsten zur Regelung des Systems verwendet werden, basieren zumeist auf dem Lorentz-Prinzip und bestehen aus einer Tauchspule und einem Permanentmagneten. Eine Komponente wird an der gelagerten Last montiert und die andere ist mit dem Boden gekoppelt.

Eine Höhensteuerung über die Magnetaktoren und die Niveauregelung einer pneumatischen Feder stößt bei großen Laständerungen an Grenzen.

Die Offenlegungsschrift EP 2 759 736 A2 (Integrated Dynamics Engineering GmbH) zeigt dagegen zur vertikalen Isolation eine Schraubenfeder, welche höhenverstellbar ist. Die Schraubenfeder ist in horizontaler Richtung steif an die Basis oder an die zu isolierende Last angebunden, was es ermöglicht, eine Höhenverstellung vorzunehmen, ohne dass es zu einer Verschiebung der zu isolierenden Last in horizontaler Richtung kommt.

### Austauschseite 3

Derartige rein mechanische Federn haben aber ein Ansprechverhalten, was sich von dem Ansprechverhalten einer pneumatischen Feder derart unterscheidet, dass für viele Anwendungen eine reine mechanische Feder nicht in Betracht kommt.

Einen weiteren Isolator zeigt das Dokument US 2005/0211515 A1. Dieser umfasst einen Faltenbalg, in welchem zwei Linearmotoren angeordnet sind. Ein Linearmotor ist in horizontaler und einer in vertikaler Richtung wirksam, so dass es sich hierbei um ein in vertikaler und in horizontaler Richtung wirksames System handelt.

Die Dokumente EP 1 803 963 A1 und EP 1 803 964 A2 offenbaren Schwingungsisolatoren, die auch als Stand der Technik betrachtet sind.

Es ist schwierig, ein pneumatisches Isolationssystem bereitzustellen, welches auch für Anwendungen geeignet ist, bei denen die isolierende Last eine hohe bewegte Masse und/oder eine hohe Beschleunigung der bewegten Masse auf das System ausübt. Hier werden hohe Kräfte benötigt, was aufgrund des begrenzten Bauraums und ggf. einer kombinierten vertikalen und horizontalen Bewegung nur in Grenzen umsetzbar ist.

### Aufgabe der Erfindung

Der Erfindung liegt demgegenüber die Aufgabe zugrunde, die genannten Nachteile des Standes der Technik zu reduzieren.

Es ist insbesondere eine Aufgabe der Erfindung, einen Schwingungsisolator bereitzustellen, welcher für ein aktives Schwingungsisolationssystem geeignet ist und welcher auf kompaktem Bauraum hohe Kompensationskräfte erzeugen kann.

### Zusammenfassung der Erfindung

Die Aufgabe der Erfindung wird bereits durch einen Schwingungsisolator nach Anspruch 1 sowie durch ein Schwingungsisolationssystem umfassend einen erfindungsgemäßen Schwingungsisolator nach Anspruch 9 gelöst.

Bevorzugte Ausführungsformen und Weiterbildungen der Erfindung sind dem Gegenstand der abhängigen Ansprüche zu entnehmen.

Die Erfindung betrifft einen Schwingungsisolator. Dieser ist insbesondere Teil eines Schwingungsisolationssystems, welches stationär aufgestellt ist und welches zur Lagerung von Geräten der Halbleiterindustrie verwendet wird. In der Regel umfasst ein derartiges Schwingungsisolationssystem einen schwingungsisoliert gelagerten Tisch oder Rahmen, auf welchem die entsprechenden Geräte gelagert sind.

Der Schwingungsisolator umfasst eine nur in einer vertikalen Richtung wirksame pneumatische Feder.

Die pneumatische Feder ist in horizontaler Richtung steif an die Basis oder an die zu isolierende Last angekoppelt und isoliert daher nur in vertikaler Richtung. Unter "horizontal" und "vertikal" wird die Richtung im eingebauten Zustand verstanden.

Weiter umfasst der Schwingungsisolator zur horizontalen Isolation ein weiteres Bauelement. Bei dem weiteren Bauelement zur horizontalen Isolation handelt es sich gemäß der Erfindung um einen Biegestab oder um ein Knickpendel handeln.

Gemäß der Erfindung ist im Arbeitsraum der pneumatischen Feder zumindest ein in vertikaler Richtung wirksamer Aktor angeordnet.

Die Verwendung eines in vertikaler Richtung wirksamen Aktors, insbesondere eines Magnetaktors, ermöglicht bei unverändertem Bauraum eine zusätzliche Schwingungsisolation in vertikaler Richtung. Der Aktor dient dabei insbesondere einer aktiven Schwingungsisolation.

Dem vorzugsweise aus Spule und Permanentmagnet gebildeten Aktor kommt zugute, dass sich die gegenüberliegenden Bauteile der pneumatischen Feder, insbesondere ein Innengehäuse und ein Außengehäuse, nicht in horizontaler Richtung bewegen.

Ein zwischen Spule und Aktor vorhandener Spalt kann daher besonders schmal sein, insbesondere eine Breite von weniger als 5 mm, bevorzugt weniger als 1 mm und besonders bevorzugt weniger als 0,5 mm aufweisen.

Hierdurch lassen sich innerhalb des Arbeitsraums der pneumatischen Feder hohe Kräfte erzeugen.

Der Biegestab oder das Knickpendel ist in einem Innengehäuse des Schwingungsisolators angeordnet, welches in den Arbeitsraum der pneumatischen Feder hineinragt.

Der Biegestab oder das Knickpendel ist also außerhalb des Arbeitsraums der pneumatischen Feder angeordnet, ragt aber über ein inneres Gehäuse, welches eine Verlängerung der zu isolierenden Last bildet und welches insbesondere zumindest abschnittsweise röhrenförmig ausgebildet ist, in den Arbeitsraum der pneumatischen Feder hinein, was ebenfalls eine kompakte Bauweise des Systems ermöglicht.

Vorzugsweise verläuft die Spule des Aktors um das Innengehäuse herum, ist insbesondere auf das Innengehäuse aufgepresst oder auf das Gehäuse geklebt und ein Magnet, insbesondere ein Permanentmagnet, verläuft entlang des Außengehäuses. Der Magnet ist insbesondere ringförmig ausgestaltet und die Spule taucht im montierten Zustand in den Magneten ein.

Es versteht sich, dass es, wie es bei einer alternativen Ausführungsform der Erfindung vorgesehen ist, auch denkbar ist, die Ausgestaltung umgekehrt vorzunehmen, also den Magnet des Aktors auf das Innengehäuse und die Spule auf das Außengehäuse aufzubringen.

Bei einer Weiterbildung der Erfindung umfasst der Isolator eine Mehrzahl von Aktoren, insbesondere von Magnetaktoren, welche übereinander angeordnet sind. Bei einer Ausführungsform umfasst der Schwingungsisolator zumindest drei übereinander angeordnete Magnetaktoren. Hierdurch lassen sich ebenfalls auf kompaktem Bauraum hohe Kräfte erzeugen.

Die in horizontaler Richtung steife Ankopplung der pneumatischen Feder kann insbesondere durch zumindest eine Blattfeder erfolgen, welche parallel zur pneumatischen Feder geschaltet ist.

Die Blattfeder kann insbesondere im Arbeitsraum der pneumatischen Feder angeordnet sein und ein Innengehäuse sowie ein Außengehäuse miteinander verbinden, welche den Arbeitsraum abschließen.

Vorzugsweise umfasst der Schwingungsisolator zumindest zwei in vertikaler Richtung voneinander beabstandete Blattfedern, um eine Verkippung des Innengehäuses gegenüber dem Außengehäuse zu verhindern.

Die Blattfeder kann Teil eines Blattfederpaketes sein.

Insbesondere können segmentierte, aus Ringsegmenten ausgebildete Blattfedern verwendet werden.

Die Blattfedern sind vorzugsweise austauschbar. Hierdurch lässt sich insbesondere die Eigenfrequenz des Schwingungsisolators auf einfache Weise einstellen. Insbesondere kann eine Eigenfrequenz von über 5 Hz erreicht werden, um kurze Ausregelzeiten zu erreichen.

Ist der erfindungsgemäße Schwingungsisolator Teil eines Schwingungsisolationssystems, so ist es insbesondere möglich, den durch den Einbau des Aktors in den Arbeitsraum gesparten Bauraum für zumindest einen außerhalb des Außengehäuses des Aktors angeordneten weiteren Aktor zu verwenden, welcher in horizontaler Richtung wirksam ist.

### Kurzbeschreibung der Zeichnungen

Der Gegenstand der Erfindung soll im Folgenden bezugnehmend auf die Zeichnungen Fig. 1 bis Fig. 4 näher erläutert werden.
Fig. 1 zeigt eine schematische Schnittansicht eines erfindungsgemäßen Schwingungsisolators.
Fig. 2 zeigt eine Ansicht des Innengehäuses.
Fig. 3 zeigt eine Ansicht des Außengehäuses.
Fig. 4 ist eine schematische Darstellung eines Schwingungsisolationsystems, welches mit erfindungsgemäßen Aktoren ausgestattet ist.

### Detaillierte Beschreibung der Zeichnungen

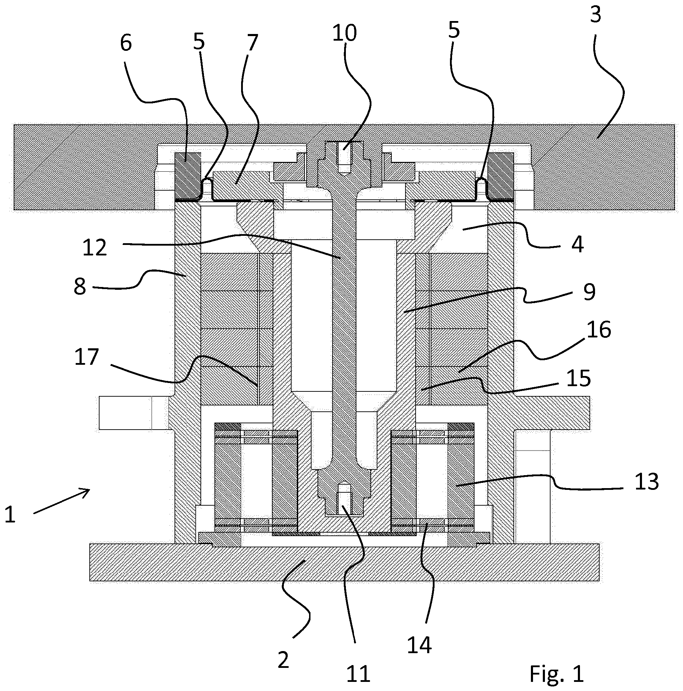

Fig. 1 zeigt in einer schematischen Schnittansicht einen erfindungsgemäßen Schwingungsisolator 1. Der Schwingungsisolator 1 ist als pneumatische Feder mit einem Arbeitsraum 4 ausgebildet und umfasst ein Basisteil 2 sowie ein Kopfteil 3, welches insbesondere als Kolbenplatte ausgebildet ist und welches mit der zu isolierenden Last verbunden wird bzw. Teil der zu isolierenden Last ist.

Die pneumatische Feder besteht aus einem auf dem Basisteil 2 montierten Außengehäuse 8 sowie einem Innengehäuse 9. Außengehäuse 8 und Innengehäuse 9 sind über eine elastische Membran 5 verschlossen. Die Membran 5 ist mittels des Spannrings 6 am Außengehäuse und mittels des Spannrings 7 am Innengehäuse 9 befestigt.

Aufgrund des im Arbeitsraums 4 vorhandenen Drucks, welcher über ein pneumatisches Regelventil (nicht dargestellt) gesteuert werden kann, wird das Innengehäuse 9 gegenüber dem Außengehäuse 8 pneumatisch abgestützt und ist aufgrund der Elastizität der Membran 5 in vertikaler Richtung beweglich.

Um die pneumatische Feder in horizontaler Richtung steif an das Basisteil 2 anzukoppeln, ist zwischen Innengehäuse 9 und Außengehäuse 8 ein Blattfederpaket 13 mit einer Mehrzahl voneinander, in vertikaler Richtung beabstandeter Blattfedern 14 vorhanden.

In diesem Ausführungsbeispiel erfolgt die Verbindung von Innengehäuse 9 und Außengehäuse 8 über eine Befestigung des Blattfederpakets 13 an dem Basisteil 2.

Für eine Isolationswirkung in horizontaler Richtung ist ein Biegestab 12 vorgesehen, welcher über die Schraube 10 mit dem Kopfteil und über die Schraube 11 mit dem Innengehäuse 9 verbunden ist.

Das Innengehäuse 9 ist zumindest abschnittsweise topfförmig ausgebildet und ragt vom Kopfteil 3 ausgehend in den Arbeitsraum 4 der pneumatischen Feder hinein. So wird eine kompakte Bauweise ermöglicht, gleichzeitig ist der Kipppunkt nach unten verlegt, was das System stabilisiert.

Das Innengehäuse 9 ist auf seiner Außenseite zumindest abschnittweise kreiszylindrisch ausgebildet und mit zumindest einer Spule 15 versehen. In diesem Ausführungsbeispiel sind mehrere Spulen 15 übereinander auf das Innengehäuse 9 gespannt.

Um einen Magnetaktor auszubilden, sind in das Außengehäuse 8 gegenüber den Spulen 15 ringförmige Magnete 16 eingebracht. Gegenüberliegende Spulen 15 und Magnete 16 bilden jeweils einen Magnetaktor.

Dies ermöglicht eine einfache Ausgestaltung und ggf. auch einen nachträglichen Einbau in einen Schwingungsisolator.

Vorzugsweise werden zunächst das Innengehäuse 9 mit den Spulen 15 und sodann das Außengehäuse 8 mit den Magneten 16 montiert und sodann diese beiden Baugruppen zusammengeführt.

Da die pneumatische Feder nur in vertikaler Richtung wirksam ist, ist der Spalt zwischen Spule 15 und Magnet 16 schmal, was eine hohe Krafterzeugung auf kompaktem Bauraum ermöglicht.

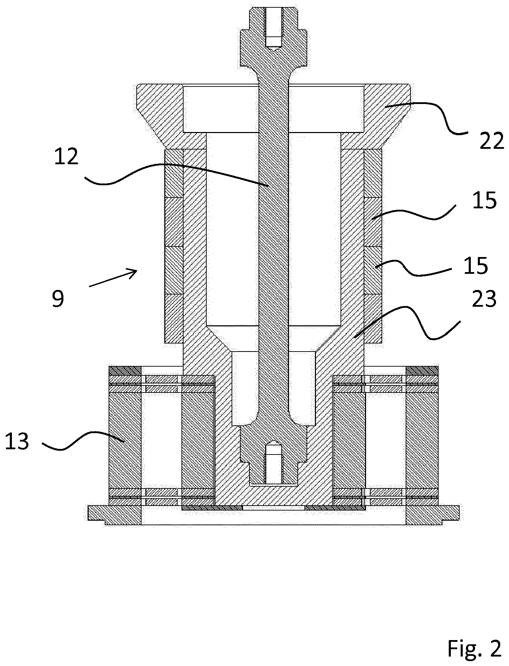

Fig. 2 zeigt in einer schematischen Schnittansicht das vormontierte Innengehäuse des in Fig. 1 dargestellten Schwingungsisolators.

Auf das Innengehäuse 9 werden die Spulen 15 aufgeklemmt.

Das Innengehäuse 9 besteht aus einem Unterteil 23 und einem darauf angebrachten Oberteil 22, welches als Anschlag für die Spulen 15 dienen kann.

Das Unterteil 23 verjüngt sich im Bereich des Blattfederpaketes 13.

Ansonsten ist das Innengehäuse 9 topfförmig ausgebildet und der Biegestab 12 ist am Boden des Innengehäuses 9 befestigt.

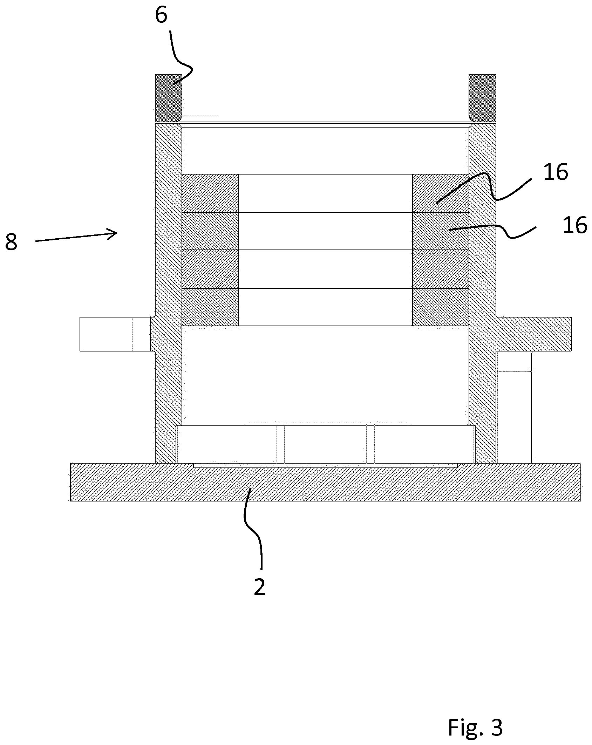

Fig. 3 ist eine schematische Schnittansicht des Außengehäuses 8.

Zu erkennen ist, dass ringförmige Magnete 16 in das kreiszylindrisch ausgebildete Außengehäuse 8 eingeschoben sind. Diese können beispielsweise mittels einer Klebeverbindung (nicht dargestellt) befestigt werden.

Weiter zu erkennen ist der hier aufgesetzte Spannring 6, welcher der Befestigung der Membran (5 in Fig. 1) dient. Es versteht sich, dass dieser Spannring 6 zur Montage abgenommen werden muss.

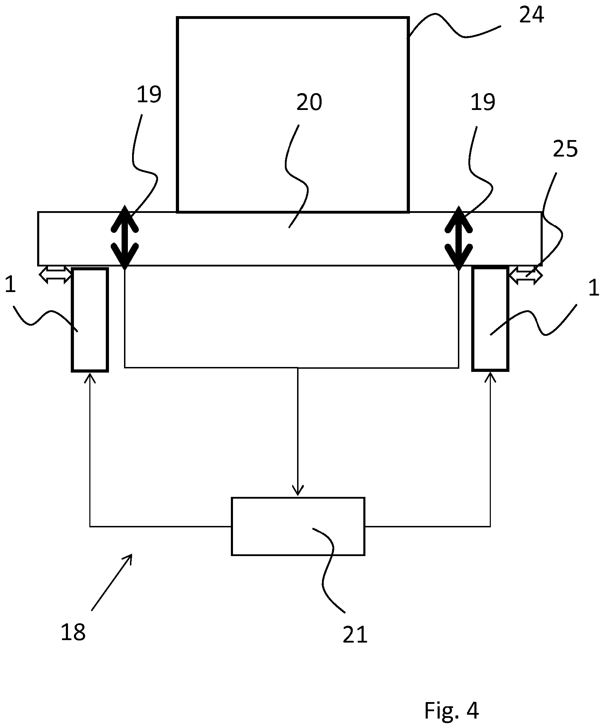

Fig. 4 zeigt eine schematische Darstellung eines Schwingungsisolationssystems 18. Dieses umfasst einen schwingungsisoliert gelagerten Tisch 20, auf welchem ein Gerät zur Prozessierung von Halbleiterbauelementen 24 angeordnet ist.

An dem Tisch 20 sind Sensoren 19 angeordnet. Diese erfassen Schwingungen der zu isolierenden Last und können als Geschwindigkeits-, Beschleunigungs- oder Abstandssensoren ausgebildet sein.

Die Sensoren 19 sind mit einer Regeleinrichtung 21 gekoppelt, welche die Schwingungsisolatoren 1, auf denen der Tisch 20 ruht, ansteuern.

In diesem Ausführungsbeispiel wird über die Regeleinrichtung 21 sowohl ein pneumatisches Regelventil für die pneumatische Feder als auch der im Schwingungsisolator 1 vorhandene Magnetaktor angesteuert.

Außerhalb des Gehäuses des Schwingungsisolators 1 sind Aktoren 25 angeordnet, welche eine aktive Regelung in horizontaler Richtung ermöglichen. Auch diese werden aktiv auf Basis von Sensoren angesteuert. Die diesbezügliche Regelschleife ist nicht dargestellt.

Durch die Erfindung konnte auf kompaktem Bauraum ein auf dem pneumatischen Prinzip wirksamer Schwingungsisolator bereitgestellt werden, welcher eine aktive Regelung mit hohen Regelkräften ermöglicht.

### Bezugszeichenliste

- 1: Schwingungsisolator
- 2: Basisteil
- 3: Kopfteil
- 4: Arbeitsraum
- 5: Membran
- 6: Spannring
- 7: Spannring
- 8: Außengehäuse
- 9: Innengehäuse
- 10: Schraube
- 11: Schraube
- 12: Biegestab
- 13: Blattfederpaket
- 14: Blattfeder
- 15: Spule
- 16: Magnet
- 17: Spalt
- 18: Schwingungsisolationssystem
- 19: Sensor
- 20: Tisch
- 21: Regeleinrichtung
- 22: Oberteil
- 23: Unterteil
- 24: Gerät zur Prozessierung von Halbleiterbauelementen
- 25: Aktor

## Patentansprüche

1. Schwingungsisolator (1), umfassend eine pneumatische Feder mit einem Arbeitsraum (4), wobei der Schwingungsisolator (1) ein weiteres Bauelement zur Schwingungsisolation in horizontaler Richtung aufweist, welches als Biegestab (12) oder Knickpendel ausgebildet ist, wobei die pneumatische Feder in horizontaler Richtung steif an die Basis oder an die zu isolierende Last angekoppelt ist und so nur in einer vertikalen Richtung wirksam ist, **dadurch gekennzeichnet, dass** im Arbeitsraum (4) zumindest ein in vertikaler Richtung wirksamer Aktor angeordnet ist und, dass der Biegestab (12) oder das Knickpendel in einem Innengehäuse (9) des Schwingungsisolators (1) angeordnet ist, welches in den Arbeitsraum (4) der pneumatischen Feder hineinragt.

2. Schwingungsisolator (1) nach dem vorstehenden Anspruch, **dadurch gekennzeichnet, dass** der Aktor als Magnetaktor ausgebildet ist.

3. Schwingungsisolator (1) nach einem der vorstehenden Ansprüche, **dadurch gekennzeichnet, dass** der Schwingungsisolator ein Innengehäuse (9) und ein Außengehäuse (8) aufweist, zwischen welchen der Arbeitsraum angeordnet ist.

4. Schwingungsisolator (1) nach dem vorstehenden Anspruch, **dadurch gekennzeichnet, dass** um das Innengehäuse herum zumindest eine Spule (15) und entlang des Außengehäuses zumindest ein Magnet (15) verläuft.

5. Schwingungsisolator (1) nach einem der vorstehenden beiden Ansprüche, **dadurch gekennzeichnet, dass** eine Mehrzahl von Aktoren, insbesondere von Magnetaktoren, übereinander angeordnet ist.

6. Schwingungsisolator (1) nach einem der vorstehenden Ansprüche, **dadurch gekennzeichnet, dass** der Aktor als Magnetaktor ausgebildet ist und eine Spule (15) sowie einen Magnet (16) umfasst, wobei ein Spalt (17) zwischen Spule (15) und Magnet (16) eine Breite von weniger als 5 mm, bevorzugt weniger als 1 mm und besonders bevorzugt weniger als 0,5 mm aufweist.

7. Schwingungsisolator (1) nach einem der vorstehenden Ansprüche, **dadurch gekennzeichnet, dass** im Arbeitsraum (4) der pneumatischen Feder zumindest eine Blattfeder (14) angeordnet ist, welche parallel zur pneumatischen Feder geschaltet ist.

8. Schwingungsisolator (1) nach dem vorstehenden Anspruch, **dadurch gekennzeichnet, dass** die Blattfeder (14) Teil eines Blattfederpakets ist.

9. Schwingungsisolationssystem (18), umfassend zumindest einen Schwingungsisolator nach einem der vorstehenden Ansprüche.

10. Schwingungsisolationssystem (18) nach dem vorstehenden Anspruch, **dadurch gekennzeichnet, dass** das Schwingungsisolationssystem Gerät zur Prozessierung von Halbleiterbauelementen (24), insbesondere ein Lithografiegerät, ein optisches Inspektionsgerät oder eine Wafer-Handling-Einrichtung umfasst.

11. Schwingungsisolationssystem (18) nach einem der vorstehenden Ansprüche, **dadurch gekennzeichnet, dass** das Schwingungsisolationssystem (18) zumindest einen Sensor zur Erfassung von Schwingungen einer schwingungsisoliert gelagerten Last oder des Bodens, auf welchem das Schwingungsisolationssystem angeordnet ist, sowie eine Regeleinrichtung (21) umfasst, über welche die pneumatische Feder und/oder der Aktor aktiv auf Basis von Signalen des zumindest einen Sensors angesteuert wird.

12. Schwingungsisolationssystem (18) nach einem der vorstehenden Ansprüche, **dadurch gekennzeichnet, dass** außerhalb eines Außengehäuses (8) des Aktors zumindest ein weiterer in horizontaler Richtung wirksamer Aktor (25) angeordnet ist.

## Claims

1. A vibration isolator (1), comprising a pneumatic spring having a working space (4), wherein the vibration isolator (1) comprises a further component for vibration isolation in horizontal direction, which is in the form of a flexible rod (12) or a buckling pendulum;
wherein the pneumatic spring is coupled rigidly to the base or to the load to be isolated in the horizontal direction and is thus effective only in a vertical direction;
**characterized in that** at least one actuator effective in the vertical direction is arranged in the working space (4); and that the flexible rod (12) or the buckling pendulum is arranged in an inner housing (9) of the vibration isolator (1), which projects into the working space (4) of the pneumatic spring.

2. The vibration isolator (1) according to the preceding claim, **characterized in that** the actuator is in the form of a solenoid actuator.

3. The vibration isolator (1) according to any one of the preceding claims, **characterized in that** the vibration isolator has an inner housing (9) and an outer housing (8) with the working space provided therebetween.

4. The vibration isolator (1) according to the preceding claim, **characterized in that** at least one coil (15) extends around the inner housing and at least one magnet (15) extends along the outer housing.

5. The vibration isolator (1) according to any one of the preceding two claims, **characterized in that** a plurality of actuators, in particular solenoid actuators, are superposed.

6. The vibration isolator (1) according to any one of the preceding claims, **characterized in that** the actuator is in the form of a solenoid actuator and comprises a coil (15) and a magnet (16), wherein a gap (17) between the coil (15) and the magnet (16) has a width of less than 5 mm, preferably less than 1 mm, and most preferably of less than 0.5 mm.

7. The vibration isolator (1) according to any one of the preceding claims, **characterized in that** at least one leaf spring (14) is arranged in the working space (4) of the pneumatic spring, which is connected in parallel to the pneumatic spring.

8. The vibration isolator (1) according to the preceding claim, **characterized in that** the leaf spring (14) forms part of a leaf spring package.

9. A vibration isolation system (18), comprising at least one vibration isolator according to any one of the preceding claims.

10. The vibration isolation system (18) according to the preceding claim, **characterized in that** the vibration isolation system comprises equipment for processing semiconductor devices (24), in particular lithography equipment, optical inspection equipment, or wafer handling equipment.

11. The vibration isolation system (18) according to any one of the preceding claims, **characterized in that** the vibration isolation system (18) comprises at least one sensor for detecting vibrations of a load mounted for vibration isolation or of the ground on which the vibration isolation system is disposed, and a control device (21) for actively controlling the pneumatic spring and/or the actuator on the basis of signals from the at least one sensor.

12. The vibration isolation system (18) according to any one of the preceding claims, **characterized in that** at least one further actuator (25) is arranged outside of an outer housing (8) of the actuator and is effective in the horizontal direction.

## Revendications

1. Isolateur de vibrations (1), comportant un ressort pneumatique ayant un espace de travail (4), l'isolateur de vibrations (1) présentant un autre composant pour l'isolation des vibrations dans la direction horizontale, lequel est conçu en tant que barre de flexion (12) ou pendule de flexion, le ressort pneumatique étant couplé dans la direction horizontale de façon rigide à la base ou à la charge à isoler et étant ainsi actif seulement dans une direction verticale, **caractérisé par le fait qu'**au moins un actionneur actif dans la direction verticale est disposé dans l'espace de travail (4), et que la barre de flexion (12) ou le pendule de flexion est disposé dans un boîtier intérieur (9) de l'isolateur de vibrations (1), lequel se projette dans l'espace de travail (4) du ressort pneumatique.

2. Isolateur de vibrations (1) selon la revendication précédente, **caractérisé par le fait que** l'actionneur est conçu en tant qu'actionneur à aimant.

3. Isolateur de vibrations (1) selon l'une des revendications précédentes, **caractérisé par le fait que** l'isolateur de vibrations présente un boîtier intérieur (9) et un boîtier extérieur (8) entre lesquels est disposé l'espace de travail.

4. Isolateur de vibrations (1) selon la revendication précédente, **caractérisé par le fait qu'**au moins une bobine (15) s'étend autour du boîtier intérieur et au moins un aimant (15) s'étend le long du boîtier extérieur.

5. Isolateur de vibrations (1) selon l'une des deux revendications précédentes, **caractérisé par le fait que** plusieurs actionneurs, en particulier des actionneurs à aimant, sont superposés.

6. Isolateur de vibrations (1) selon l'une des revendications précédentes, **caractérisé par le fait que** l'actionneur est conçu en tant qu'actionneur à aimant et comporte une bobine (15) ainsi qu'un aimant (16), un entrefer (17) entre bobine (15) et aimant (16) présentant une largeur inférieure à 5 mm, de préférence inférieure à 1 mm et de manière particulièrement préférée inférieure à 0,5 mm.

7. Isolateur de vibrations (1) selon l'une des revendications précédentes, **caractérisé par le fait que**, dans l'espace de travail (4) du ressort pneumatique, est disposé au moins un ressort à lame (14), lequel est monté en parallèle avec le ressort pneumatique.

8. Isolateur de vibrations (1) selon la revendication précédente, **caractérisé par le fait que** le ressort à lame (14) fait partie d'un paquet de ressorts à lame.

9. Système d'isolation de vibrations (18), comportant au moins un isolateur de vibrations selon l'une des revendications précédentes.

10. Système d'isolation de vibrations (18) selon la revendication précédente, **caractérisé par le fait que** le système d'isolation des vibrations comporte un appareil pour le traitement de dispositifs à semi-conducteurs (24), en particulier un appareil de lithographie, un appareil d'inspection optique ou un dispositif de manipulation de plaquettes.

11. Système d'isolation de vibrations (18) selon l'une des revendications précédentes, **caractérisé par le fait que** le système d'isolation de vibrations (18) comporte au moins un capteur pour la détection de vibrations d'une charge montée pour l'isolation des vibrations ou du sol sur lequel le système d'isolation des vibrations est disposé, ainsi qu'un dispositif de commande (21) par lequel le ressort pneumatique et/ou l'actionneur sont commandés activement sur la base de signaux dudit au moins un capteur.

12. Système d'isolation de vibrations (18) selon l'une des revendications précédentes, **caractérisé par le fait qu'**au moins un autre actionneur (25) actif dans la direction horizontale est disposé à l'extérieur d'un boîtier extérieur (8) de l'actionneur.
